# EUROPEAN PATENT SPECIFICATION

(11) **EP 3 051 596 B1**
(45) Date of publication and mention of the grant of the patent: **25.12.2019**
(21) Application number: 14847054.5
(22) Date of filing: 23.09.2014
(51) Int. Cl.: H01L 31/18

(54) **METHOD FOR MODIFYING CDTE LAYER OF CDTE THIN-LAYER SOLAR CELL**
VERFAHREN ZUR MODIFIZIERUNG DER CDTE-SCHICHT EINER CDTE-DÜNNSCHICHT-SOLARZELLE
PROCÉDÉ POUR MODIFIER UNE COUCHE DE CDTE D'UNE CELLULE SOLAIRE À COUCHES MINCES AU CDTE

(30) Priority: 26.09.2013 CN 201310446482
(43) Date of publication of application: 03.08.2016
(73) Proprietor: China Triumph International Engineering Co., Ltd., Shanghai 200063 (CN); CTF Solar GmbH, 01099 Dresden (DE)
(72) Inventor: DROST, Christian, 04157 Leipzig (DE); SPAETH, Bettina, 01099 Dresden (DE); PENG, Shou, Shanghai 200063 (CN)
(74) Representative: Kailuweit & Uhlemann Patentanwälte Partnerschaft mbB
(86) International application number: PCT/CN2014/087202
(87) International publication number: WO 2015/043454

(56) References cited:
- CN-A- 101 615 638
- CN-A- 102 723 384
- JP-A- 2005 308 705
- US-A- 2 822 250
- US-A- 4 456 630
- BARKER J: "ELECTRODEPOSITED CDTE FOR THIN FILM SOLAR CELLS", INTERNATIONAL JOURNAL OF SOLAR ENERGY, HARWOOD ACADEMIC PUBLISHERS, LONDON, GB, vol. 12, no. 1 / 04, 1 January 1992 (1992-01-01), pages 79-94, XP000362603, ISSN: 0142-5919
- SOBIESIERSKI Z ET AL: "CORRELATION OF PHOTOLUMINESCENCE MEASUREMENTS WITH THE COMPOSITION AND ELECTRONIC PROPERTIES OF CHEMICALLY ETCHED CDTE SURFACES", APPLIED PHYSICS LETTERS, A I P PUBLISHING LLC, US, vol. 53, no. 26, 26 December 1988 (1988-12-26), pages 2623-2625, XP000080686, ISSN: 0003-6951, DOI: 10.1063/1.100178
- MENEZES F D ET AL: "New methodology for obtaining CdTe quantum dots by using ultrasound", ULTRASONICS: SONOCHEMISTRY, BUTTERWORTH-HEINEMANN, GB, vol. 18, no. 5, 17 March 2011 (2011-03-17) , pages 1008-1011, XP028218153, ISSN: 1350-4177, DOI: 10.1016/J.ULTSONCH.2011.03.020 [retrieved on 2011-03-24]

## Description

The subject matter of the present invention is a method for conditioning the CdTe layer of CdTe thin-film solar cells, so that improved contacting with the rear contact layer sequence is made possible.

According to the state of the art, CdTe thin-film solar cells in a superstrate configuration are produced by applying a transparent front contact layer (TCO - transparent conductive oxide) to a substrate (preferably glass). A layer of pure or modified CdS (cadmium sulfide) is deposited on this. Modified CdS (cadmium sulfide) is understood below to refer to CdS with dopants, variations in crystal form or grain sizes or as a mixture of CdS with other substances. A layer of cadmium telluride (CdTe) is applied over the CdS layer. The rear contact layer, i.e. the rear contact layer sequence, in turn, is deposited on the CdTe layer.

One problem here is that it is not readily possible to apply a metallic contact layer to the CdTe because this would result in the development of a rectifying Schottky contact. However, what is desired is formation of an ohmic contact. The purpose of the layer sequence is to implement the equalization of the energy levels of the individual layer materials, so that an ohmic contact is formed, wherein the top rear contact layer is preferably a metallic layer.

After applying the CdTe during the production process, the CdTe is preferably activated by means of CdCl2 and heating.

According to state-of-the-art methods, the cadmium telluride layer must then be subjected to a wet chemical etching. For this purpose, the CdTe solar cell is immersed in a so-called NP etching. The NP etching is an aqueous solution of various inorganic acids, preferably HNO3 (0.5%-5%)/ H3PO4 (50%-85%)/ H2O (15%-45%) (total 100%). This takes place in a temperature range from room temperature (18°C) to approximately 80°C. The etching time is preferably in the range of 5 s to 60 s. NP etching results in the formation of a Te-rich (tellurium-rich) layer with a thickness in the range of 1 nm to 300 nm.

Because of the action of the HNO3, the NP etching results in oxidation of CdTe to amorphous elemental Te, which crystallizes and forms the Te-rich layer. However, oxidation does not stop at elemental Te. Some of the Te present is also oxidized to tellurium oxides (for example, TeO2), which is unwanted. These oxides remain mostly in the tellurium-rich layer, where they are present in particular at the grain boundary gussets of the CdTe/Te transitions (the transitional region from the undisturbed CdTe layer to the Te-rich layer). In addition, the Te-rich layer is susceptible to oxidation due to atmospheric oxygen. This additional oxidation degrades the good p-conductivity of the Te layer and the conductivity to the CdTe layer. In addition, the oxidized regions result in degraded contacting with the secondary rear contact layers (for example, the Sb2Te3, Mo, Ni:V layer sequence).

There have been numerous proposals for how to improve the etching of the CdTe surface and the condition of the CdTe layer after an NP etching.

US 2011/0117696A1 thus proposes a modified etching process for creating a Te-rich and oxide-free layer, wherein this process works with a mixture of an organic acid, an oxidizing agent and a complexing agent. Acids mentioned specifically include gluconic acid, acetic acid, citric acid and mixtures thereof. Hydrogen oxide is mentioned as the oxidizing agent. The complexing agents should preferably be capable of complexing copper. In own studies, however, the proposed etchant has proven to be less effective in creating a Te-rich layer and in particular has proven to be unsuitable for industrial production of solar cells.

US Patent 4,456,630 describes another procedure in which the CdTe layer is etched with a strong acid, preferably an oxidizing acid. Sulfuric acid, nitric acid, hydrochloric acid and hydrofluoric acid are mentioned in particular for this purpose. Then the surface is treated with an oxidizing agent, preferably a dichromate or peroxide. Next the oxides thereby formed are reduced and/or removed by means of a strongly basic chemical. The use of hydrazine or an alkali metal hydroxide solution is mentioned specifically. For example, this document mentions 2 s (column 2, line 61) as the etching time with the oxidizing acid. Such short etching times are difficult to control and can result in great fluctuations in quality. In addition, it is characteristic of the use of alkali metal hydroxide solutions, such as NaOH or KOH, that the tellurium oxides are dissolved out of the treated Te-rich surface. The latter may have negative effects on the layer thickness of the Te-rich layer. Using hydrazine as a reducing agent also necessitates handling of a highly toxic carcinogenic substance. This method is thus extremely time critical and requires handling of strong acids, bases and/or toxic substances.

Barker et al., "Electrodeposited CdTe for thin film solar cells", Intern. Journ. of Solar Energy, Vol. 12 (1992), No. 1/4, describes processes for producing CdTe thin film solar cells. It is disclosed that a Te-rich surface layer of a CdTe layer is formed by bromine/methanol etching. Further, a subsequent treatment by a reducing agent is performed in order to get an essentially oxide free surface layer, without specifying the reducing agent in detail US 4 456 630 A discloses a method of forming ohmic contacts with thin film CdTe compounds comprising etching the film surface with an acidic solution, then etching with a strong basic solution and finally depositing a conductive metal layer.

The object that arises is thus to improve upon the NP etching process and/or a downstream process, so that the amount of tellurium oxide compounds in the Te-rich layer is minimized but no highly dangerous chemicals need to be used.

According to the invention, this object is achieved with the method according to Claim 1. Advantageous embodiments are disclosed in the dependent claims which refer back to previous claims.

According to the state of the art, a semifinished thin-film solar product in a superstrate configuration is made available. It preferably has a substrate, a front contact layer arranged on the substrate and a layer of pure or modified CdS arranged on the front contact layer. A CdTe layer is applied to the CdS layer. The CdTe layer has been subjected to an NP etching, so that the topmost layer of the CdTe layer is rich in Te, i.e., the layer contains Te in a superstoichiometric ratio.

The invention provides that the NP etching, which is a well-managed process in the state of the art, is to be supplemented by an additional reduction step following the NP etching. This reductive treatment is aimed at eliminating most of the tellurium oxide compounds present in the Te-rich layer. For this purpose, an aqueous solution of suitable chemicals is brought in contact with the surface of the Te-rich layer, under atmospheric conditions. This is done by means of a state-of-the-art immersion method using a wet bench. Suitable chemicals include:
- sodium dithionite (Na₂S₂O₄) in a neutral or weakly acidic solution (0.01 to 1 molar) or
- stannous chloride (SnCl₂) in HCl acidic solution (0.005 to 1 molar) or
- sodium borohydride (NaBH₄) in a neutral or weakly basic solution (0.001 to 2 molar).

With the treatment in the immersion method, the solar cells as semifinished products are immersed for 1 sec to 30 min in one of the solutions mentioned above. This is preferably done in the temperature interval of 15°C to 30°C. Next, the semifinished solar cell products are rinsed with deionized water, dried and sent for further processing (application of the rear contact layer sequence).

Particularly preferred embodiments of the inventive reduction of the Te-rich layer, which is partially oxidized by the action of the NP etching (HNO₃), indude:
(i) aqueous solution of sodium dithionite Na₂S₂O₄: 0.01 to 1 molar solutions (preferred range: approximately 0.03-0.04 molar)
(ii) weakly acidic aqueous Na₂S₂O₄ solutions, e.g., by acidifying with citric acid or EDTA.
   The reduction according to (i) and (ii) is preferably performed at a solution temperature of approximately 20°C. The solution is preferably prepared anew or refreshed regularly, because gradual decomposition of the sodium dithionite in water can be expected. The reduction process preferably lasts between 10 s and 300 s, especially preferably between 30 s and 120 s.
(iii) by means of aqueous acidic solutions of stannous chloride: 0.005 to 1 molar solutions, weakly acidified with dilute HCI (preferred range: approximately 0.02-0.05 molar). The temperature of the solution is approximately 20°C with the reduction process lasting preferably 10 s-120 s.
(iv) by means of an aqueous solution of sodium borohydride:
   preferably 0.001 to 2 molar (especially preferred concentration range: 0.04-0.8 molar). The temperature of the solution is in the preferred temperature range between 15°C and 30°C. The treatment time is preferably between 10 s and 300 s, especially preferably between 30 s and 60 s.

After NP etching, the tellurium-enriched surface layer preferably has a thickness of 1 nm to 300 nm, especially preferably of 50 nm to 150 nm. The thickness changes only insignificantly or not at all as a result of the additional reduction step according to the invention.

The treatment according to the invention with reducing chemicals results in the tellurium oxides releasing the bound oxygen to the chemicals. As a result of the treatment according to the invention, most of the tellurium oxides in the Te-rich layer (41) are reduced, but at least to one-fifth, preferably to one-twentieth, especially preferably to one-hundredth of their amount by weight in the Te-rich layer. The tellurium remains in the Te-rich layer, so that the abrasion and/or dilution of the Te-rich layer, such as that which occurs with US Patent 4,456,630, for example, is prevented. In addition, the process can take place at room temperature and/or a temperature that is only slightly elevated. In addition, wet chemical processes can be managed well on a large scale industrially.

After the additional reduction step according to the invention and the subsequent rinsing with deionized water, an Sb₂Te₃ layer is applied using state-of-the-art methods, preferably by sputtering of Sb₂Te₃. Then additional layers of the rear contact layer sequence are applied, typically layers of molybdenum and nickel.

### FIGURES

The figures of Fig.1 to Fig. 5 show schematically the sequence of the process steps including the additional reducing process according to the invention step after NP etching.
- FIG. 1: shows the prepared solar cell with the substrate (1) to which the transparent front contact (21) and the CdS layer (3) are applied, with the CdTe layer (4) applied above it already.
- FIG. 2: shows schematically the etching process by means of NP etching (6).
- FIG. 3: After the etching process, there remains a Te-rich layer (41), from which most of the Cd has been dissolved, as shown schematically in Fig. 3.
- FIG. 4: shows schematically that the surface is treated with a reducing chemical (7) after the etching process.
- FIG. 5: shows schematically the layer sequence of the finished solar cell after applying the rear contact (22) to the Sb₂Te₃ layer (5). The rear contact layer (22) may be formed as a layer sequence.

### Exemplary Embodiment

The process according to the invention is explained below on the basis of one exemplary embodiment although it is not limited to this example.

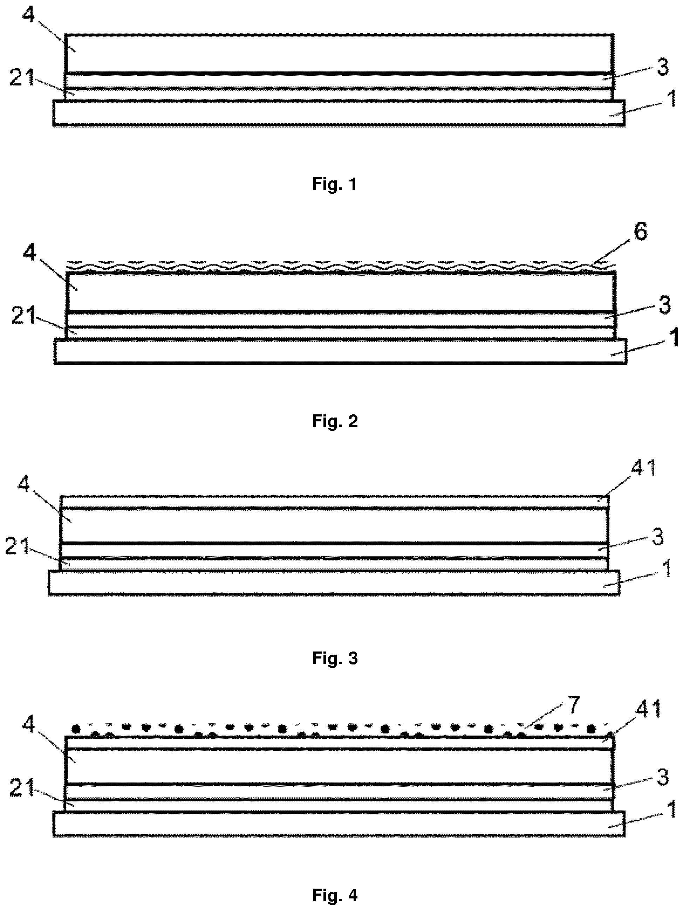

After applying the front contact layer (21), the CdS layer (3) and the CdTe layer (4) to the glass substrate (1) (Fig. 1), the CdTe surface layer is activated with CdCl2 at 400°C according to the state of the art. Next the NP etching step is carried out (Fig. 2) with an NP etching solution (6): (HNO3 (3%)/ H3PO4 (75%)/ H2O (22%) at a temperature of 30°C. This forms a Te-rich layer (41) with a layer thickness of 250 nm (Fig. 3). The oxidic components have been only partially dissolved out of this layer but most of the cadmium has been dissolved out of it.

Next the aftertreatment according to the invention is carried out with a reducing chemical (7), namely a neutral sodium dithionite solution (3%) for 2 min at 20°C in this case (Fig. 4). This is carried out in a wet bath according to the state of the art.

There follows a rinsing operation using deionized water and a subsequent drying.

Next a 45 nm thick Sb2Te3 layer (5) is formed on the Te-rich layer (41) by sputtering at a substrate temperature of 250°C.

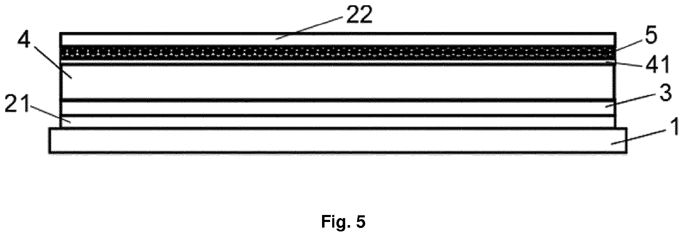

Next, the rear contact layer (22), consisting of a layer sequence of a molybdenum layer and a nickel layer with vanadium as an additive, is deposited. The molybdenum layer (150 nm) is deposited on the Sb2Te3 layer by sputtering. In conclusion, a nickel layer with added vanadium is also deposited on the molybdenum layer (sputtering, 150 nm) (Fig. 5).

### Reference Numerals

- 1: substrate (glass)
- 21: front contact (transparent, TCO)
- 22: rear contact (metal)
- 3: CdS layer (pure or modified CdS (cadmium sulfide))
- 4: CdTe layer
- 41: Te-rich layer after etching
- 5: Sb2Te3 layer
- 6: NP etching
- 7: reducing chemical

## Claims

1. A method for treatment of the CdTe layer of semifinished thin-film solar cell products in a superstrate configuration, having a CdTe layer as the topmost layer, wherein the CdTe layer has a Te-rich surface layer which is largely freed of the tellurium oxides present there by reducing these tellurium oxides to tellurium by using a reducing agent, wherein the reducing step is carried out by immersing the semifinished thin-film solar cell products in a wet bath, wherein the reducing agent is brought in contact with the surface of the Te-rich layer under atmospheric conditions and at a temperature in the range of 15°C to 30°C, **characterized in that** a neutral or weakly acidic aqueous Na₂S₂O₄ solution or an aqueous acidic solution of stannous chloride or an aqueous sodium borohydride solution is used as the reducing agent.

2. The method according to Claim 1, **characterized in that** the Te-rich surface layer is created by an NP etching step using a composition comprising phosphoric acid (H₃PO₄) (50%-85%), nitric acid (HNO₃) (0.5%-5%) and water (15%-45%) (total 100%) or by etching using a bromine/methanol mixture.

3. The method according to any one of the preceding claims, **characterized in that** the Te-rich surface layer is rinsed with deionized water after the reducing step.

4. The method according to Claim 3, **characterized in that** a rear contact layer sequence is applied after the rinsing.

## Patentansprüche

1. Verfahren zur Behandlung der CdTe-Schicht von Dünnschicht-Solarzellen-Halbzeugen in Superstrat-Konfiguration, die eine CdTe-Schicht als oberste Lage aufweisen, wobei die CdTe-Schicht eine Te-reiche Oberflächenschicht aufweist, die von den dort vorhandenen Telluroxiden weitestgehend befreit wird, indem diese Telluroxide mittels eines Reduktionsmittels zu Tellur reduziert werden, wobei der Reduktionsschritt durch Eintauchen der Dünnschicht-Solarzellen-Halbzeuge in ein Nassbad erfolgt, wobei das Reduktionsmittel mit der Oberfläche der Te-reichen Schicht unter atmosphärischen Bedingungen und bei einer Temperatur im Bereich von 15°C bis 30°C in Kontakt gebracht wird, **dadurch gekennzeichnet, dass** als Reduktionsmittel eine neutrale oder schwach saure wässrige Na₂S₂O₄ Lösung oder eine wässrige saure Lösung von Zinn(II)chlorid oder eine wässrige Natriumborhydrid-Lösung verwendet wird.

2. Verfahren nach Anspruch 1, **dadurch gekennzeichnet, dass** die Te-reiche Oberflächenschicht durch einen NP-Ätzschritt unter Nutzung einer Zusammensetzung enthaltend Phosphorsäure (H₃PO₄) (50%-85%), Salpetersäure (HNO₃) (0,5%-5%) und Wasser (H₂O) (15%-45%) (Summe 100%) oder durch eine Ätzung mit einem Brom/Methanol Gemisch erzeugt wird.

3. Verfahren nach einem der vorhergehenden Ansprüche, **dadurch gekennzeichnet, dass** nach dem Reduktionsschritt eine Spülung der Te-reichen Oberflächenschicht mit deionisiertem Wasser vorgenommen wird.

4. Verfahren nach Anspruch 3, **dadurch gekennzeichnet, dass** eine Rückkontaktschichtfolge nach der Spülung aufgebracht wird.

## Revendications

1. Procédé de traitement de la couche de CdTe de produits de cellule photovoltaïque en couche mince semi-finis dans une configuration de superstrat, ayant une couche de CdTe comme couche supérieure, la couche de CdTe ayant une couche superficielle riche en Te qui est largement débarrassée des oxydes de tellure présents dans celle-ci par réduction de ces oxydes de tellure en tellure en utilisant un agent réducteur, l'étape de réduction étant effectuée par immersion des produits de cellule photovoltaïque en couche mince semi-finis dans un bain humide, l'agent réducteur étant amené en contact avec la surface de la couche riche en Te dans des conditions atmosphériques et à une température dans la plage de 15 °C à 30 °C, **caractérisé en ce qu'**une solution aqueuse de Na₂S₂O₄ neutre ou faiblement acide ou une solution aqueuse acide de chlorure stanneux ou une solution aqueuse de borohydrure de sodium est utilisée comme agent réducteur.

2. Procédé selon la revendication 1, **caractérisé en ce que** la couche superficielle riche en Te est créée par une étape d'attaque au NP en utilisant une composition comprenant de l'acide phosphorique (H₃PO₄) (50 % à 85 %), de l'acide nitrique (HNO₃) (0,5 % à 5 %) et de l'eau (15 % à 45 %) (total 100 %) ou par attaque en utilisant un mélange de brome/méthanol.

3. Procédé selon l'une quelconque des revendications précédentes, **caractérisé en ce que** la couche de surface riche en Te est rincée avec de l'eau désionisée après l'étape de réduction.

4. Procédé selon la revendication 3, **caractérisé en ce que** une succession de couches de contact arrière est appliquée après le rinçage.
